(19) Europäisches Patentamt
European Patent Office
Office européen des brevets

(11) Numéro de publication: **0 070 234**
**A2**

(12) # DEMANDE DE BREVET EUROPEEN

(21) Numéro de dépôt: 82401274.4

(22) Date de dépôt: 06.07.82

(51) Int. Cl.³: H 01 L 27/15
H 01 L 31/12

(30) Priorité: 15.07.81 FR 8113761

(43) Date de publication de la demande: 19.01.83 Bulletin 83/3

(84) Etats contractants désignés: DE GB NL SE

(71) Demandeur: THOMSON-CSF
173, boulevard Haussmann
F-75379 Paris Cedex 08(FR)

(72) Inventeur: Carballes, Jean-Claude
THOMSON-CSF SCPI 173, bld Haussmann
F-75379 Paris Cedex 08(FR)

(74) Mandataire: Taboureau, James et al.
THOMSON-CSF SCPI 173, Bld Haussmann
F-75379 Paris Cedex 08(FR)

(54) **Composant optoélectronique dont la structure semiconductrice comporte deux parties respectivement émettrice et réceptrice, et dispositif de régulation d'une diode électroluminescente.**

(57) L'invention vise à la fabrication, au cours d'un unique processus, d'un composant opto-électronique à partie centrale émissible et à partie périphérique réceptrice, ce qui permet soit l'émission et la réception simultanées sur des longueurs d'onde différentes, soit le contrôle local par la périphérie d'une longueur d'onde donnée émise par la partie centrale.

Le composant selon l'invention comporte, sur un même substrat (10) des couches épitaxiales successives (1,2,3) séparées en deux parties par un sillon annulaire (51) pénétrant à coeur. Une gravure mésa 11 permet de prendre un contact (8) périphérique sur le substrat (10). Entre celui-ci et des contacts (6) et (7) pris au centre et à la périphérie sur la couche supérieure (4, 3) on polarise en direct l'empilage central qui devient photo-émissif et en inverse l'empilage périphérique qui fonctionne en diode photodétectrice.

Applications aux télécommunications par fibre optique.

FIG.1

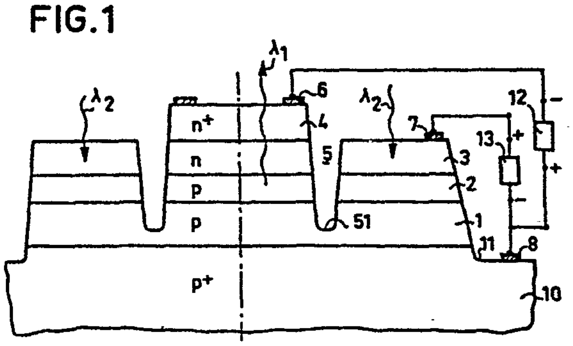


EP 0 070 234 A2

# COMPOSANT OPTOELECTRONIQUE DONT LA STRUCTURE SEMICONDUCTRICE COMPORTE DEUX PARTIES RESPECTIVEMENT EMETTRICE ET RECEPTRICE, ET DISPOSITIF DE REGULATION D'UNE DIODE ELECTROLUMINESCENTE

L'invention concerne un composant opto-électronique comportant une partie émettrice et une partie réceptrice groupées dans une même structure semiconductrice. Elle concerne également un dispositif de régulation d'une diode électroluminescente utilisant ce composant.

L'utilisation d'un composant unique placé à une extrémité d'une liaison bidirectionnelle sur fibre optique est intéressante pour éviter la servitude constituée par les moyens optiques de séparation des ondes optiques de chaque sens de transmission. Le problème se pose notamment lorsqu'on désire exploiter la liaison, non à l'alternat, mais en transmission simultanée dans les deux sens. On utilise, dans ce cas, des longueurs d'ondes différentes pour chaque sens de transmission.

L'invention permet de résoudre le problème posé ci-dessus, au moins en ce qui concerne l'extrémité où l'on reçoit la plus petite des longueurs d'onde.

Le composant selon l'invention est du type comportant en dépôts successifs sur un même substrat semiconducteur, au moins une première une deuxième et une troisième couches de composition et de dopage tels que :

- la première et la troisième couches sont constituées par un premier matériau semiconducteur formé de composés d'éléments III-V, présentant une bande interdite assez large pour être traversée facilement par un rayonnement de longueurs d'onde prédéterminée, et de dopages procurant des types de conductivité opposés ;

- la deuxième couche est constituée par un deuxième matériau semiconducteur composé d'éléments III-V, présentant une bande interdite correspondant à l'émission par ce matériau d'un rayonnement sur ladite longueur d'onde.

Il est caractérisé en ce que la structure du composant comporte une première partie destinée à l'émission et une deuxième partie destinée à la réception, les deux parties étant séparées soit par une tranchée pénétrant

dans l'ensemble des couches, soit par une région isolante créée par implantation protonique atteignant le substrat.

L'invention sera mieux comprise, et d'autres caractéristiques apparaîtront, au moyen de la description qui suit, et des dessins qui l'accompagnent ; parmi lesquels :

- La figure 1 est une coupe schématique d'un composant selon l'invention ;

- la figure 2 montre l'application de ce composant à la transmission sur fibre optique ;

- les figures 3 et 4 représentent en coupe et en vue par dessus, une variante de l'invention.

A titre d'exemple non limitatif, on prendra le cas d'une liaison bidirectionnelle à transmission simultanée dans les deux sens sur une même fibre optique, en utilisant une première longueur d'onde du domaine de 1 à 1,7 micron et une deuxième longueur d'onde du domaine de 0,8 à 0,9 micron.

Le composant selon l'invention est placé du côté où l'on émet sur la première longueur d'onde. Le matériau semiconducteur utilisé pour constituer la deuxième couche, ou couche active de diode électroluminescente, est un alliage de composition :

$$Ga_x In_{1-x} As_y P_{1-y}$$

avec : $0,3 \leqslant y \leqslant 1,0$ le substrat étant en In P et par conséquent, x vérifiant à 1% près la relation :

$$x = \frac{0,19\ y}{0,42 - 0,013y}$$

Avec les limites fixées ci-dessus pour y, x varie entre 0,14 et 0,45.

Pour obtenir par exemple la longueur d'onde de 1,3 micron, on doit avoir :

x = 0,28

y = 0,62

Figure 1, on a représenté en coupe schématique, un composant selon l'invention réalisé par exemple par un procédé comportant les étapes suivantes :

a) Formation sur un substrat 10, en In P monocristallin dopé $p^+$, d'une première couche 1 d'In P de même type de conductivité que le substrat mais

moins fortement dopé que celui-ci. Cette étape peut être réalisée par épitaxie en phase liquide ou gazeuse. L'épaisseur de cette couche est par exemple de l'ordre du micron. Elle a pour but de masquer des défauts cristallographiques éventuels du substrat et peut éventuellement être supprimée, si le substrat est de qualité suffisante.

b) Dépôt, par épitaxie en phase liquide ou gazeuse, d'une deuxième couche 2 dopée p ou n, en matériau de composition :

$Ga_x In_{1-x} As_y P_{1-y}$

avec par exemple :

x = 0,28

y = 0,62

Ces valeurs correspondent à une émission sur 1,3 micron pour un matériau de maille cristalline compatible avec In P.

L'épaisseur de cette couche est de l'ordre de 0,1 à 0,3 micron.

c) Dépôt par épitaxie d'une troisième couche 3 d'In P dopé n, d'une épaisseur de l'ordre du micron.

d) Attaque mésa de la structure constituée par le substrat 1 et les couches 1, 2 et 3, selon un sillon circulaire 5 autour de la région centrale de la structure. Le fond 51 du sillon 5 est très proche du substrat 10. L'attaque mésa est réalisée par gravure chimique ou par usinage ionique.

e) Dépôt, limité par masquage à la région centrale, d'une couche 4 d'In P dopé $n^+$.

f) Attaque mésa, sur le pourtour de la structure semiconductrice, pour mettre à nu sur une certaine largeur la périphérie 11 du substrat 10.

g) Dépôt d'un contact ohmique annulaire 6 à la périphérie de la surface libre de la couche 4, d'un contact ohmique 7 sur la surface libre de la couche 3, et d'un contact ohmique 8 sur la périphérie 11 du substrat.

Dans une variante du procédé on remplace l'attaque mésa par une implantation de protons dans une région annulaire à la place du sillon 5.

Des moyens de polarisation sont prévus pour faire fonctionner la région centrale en diode électroluminescente et la périphérie en photodiode. Ces moyens comprennent :

1°) une source de tension continue 12 dont les pôles - et + sont reliés aux contacts 6 et 8 ;

2°) une source de tension continue 13 dont les pôles + et - sont reliés aux contacts 7 et 8.

La région centrale ; polarisée en direct, fonctionne en diode électroluminescente, la région annulaire polarisée en inverse fonctionne en photodiode. On voit que, si la composition de la couche 2 est telle qu'une longueur d'onde $\lambda_1$, comprise entre 1 et 1,7 microns, soit 1,3 microns, la même couche 2, dans la région annulaire, est susceptible de détecter, dans le fonctionnement en photodiode, la longueur d'onde $\lambda_2$ de la bande de 0,8 à 0,9 micron provenant d'une diode électroluminescente placée à l'extrémité opposée de la liaison optique, diode comportant une couche active en alliage de composition :

$Ga_{1-z} Al_z As$

avec $0 < z < 0,15$

A la figure 2, on a représenté, en coupe schématique, un tronçon 20 de fibre optique comportant un coeur 21 et une gaine 22, dont l'extrémité présentant une section plane 23, est située au voisinage d'un composant selon l'invention dont on a dessiné seulement la structure semiconductrice 24.

On voit facilement que la surface de la région centrale 25 doit être inférieure à la section plane du coeur 21, afin que la majorité des rayons infrarouges 27, émis par la région 25, soient recueillis par le coeur de la fibre, en tenant compte de l'ouverture numérique de celle-ci. Mais il est vrai aussi que la région annulaire 26 doit recueillir une part suffisante des rayons 28 provenant de l'extrémité opposée de la liaison, ce qui nécessite une limitation des surfaces des régions 25 et 26. Les proportions optimales dépendent notamment de l'ouverture numérique de la fibre.

Des précautions doivent être prises pour éviter que la région annulaire 26 reçoive une partie même minime de la lumière émise par la région centrale 25. A cet effet :

1°) on réduit la transmission directe de la lumière à travers le sillon annulaire par des moyens classiques tels que le dépôt de matériau anti-reflet ;

2°) on réduit l'épaisseur de la couche 2, seule couche susceptible d'absorber la lumière indésirable ;

3°) on réduit les effets de réflexion sur la fibre optique ou tout autre paroi réfléchissante par dépôt de couche anti-reflet.

Dans une variante de l'invention, on réalise une structure analogue à celle de la figure 1, dans laquelle la partie réceptrice est destinée à recueillir, dans un but de contrôl local, une partie de la puissance lumineuse émise par la région centrale.

On décrit ci-après un exemple de cette variante, dans lequel une couche active est réalisée en alliage de Ga, d'Al et d'As, avec un substrat en Ga As, l'émission étant prévue sur une longueur d'onde comprise dans l'intervalle 0,8 à 0,9 micron.

Le composant représenté aux figures 3 (coupe) et 4 (vue par dessus) comporte une partie centrale et une partie annulaire séparées par un sillon 5 dont le fond 51 est situé dans le substrat 10 en arséniure de gallium dopé $p^+$.

Sur ce substrat, on a déposé successivement, par épitaxie, les couches suivantes :

1°) une couche 1 en matériau de formule :

$Ga_{1-z'} Al_{z'} As$ dopé p, avec :

$z' \geq 0,2$, soit, par exemple : $z' = 0,35$

l'épaisseur de cette couche étant de l'ordre du micron ;

2°) une couche 2 (couche émissive) en matériau de formule :

$Ga_{1-z} Al_z As$ dopé p (éventuellement n) avec :

$O \leq z \leq 0,15$ soit, par exemple $z = 0,05$

l'épaisseur de cette couche étant de l'ordre de deux à trois microns ;

3°) une couche 3 en matériau de formule identique à celle du matériau de la couche 1, dopé n et de même épaisseur que celle-ci ;

4°) une couche 4 en matériau de formule :

$Ga_{1-z''} Al_{z''} As$ dopé n, avec :

$z'' = z + 0,1$, soit, par exemple : $z = 0,15$

l'épaisseur de cette couche étant de l'ordre du micron.

Dans cette structure, comme dans la précédente, les dopages des diverses couches et du substrat pourraient être inversés, à condition d'inverser également les polarités des sources de tension continue appliquées aux contacts ohmiques des parties respectivement émettrice et réceptrice. Ces contacts sont ici les suivants :

1°) un contact ohmique 6 sur la région centrale mais toutefois placé en dehors de la surface émettrice 40 grâce à un prolongement 41, en forme de presqu'île, entouré par le sillon 5 ;

2°) un contact ohmique 7 sur la région annulaire, la couche 4 pouvant d'ailleurs être entièrement métallisée dans cette région, car outre le rayonnement E émis vers le haut, des photons 30 sont rayonnés latéralement dans le sillon 5 et atteignent la couche active 2 dans la région annulaire, où ils sont absorbés de façon préférentielle en raison de la bande interdite de cette couche, ces photons 30 créant, sous l'influence de la polarisation en photodiode, un courant de détection sensiblement proportionnel à l'intensité du rayonnement E ;

3°) un contact ohmique 8 sur la région 11, dégagée par attaque mésa à la périphérie de la structure, comme dans la réalisation de la figure 1.

Le dispositif de régulation d'une diode électroluminescente utilisant un composant selon l'invention est réalisé en ayant recours à la variante représentée aux figures 3 et 4.

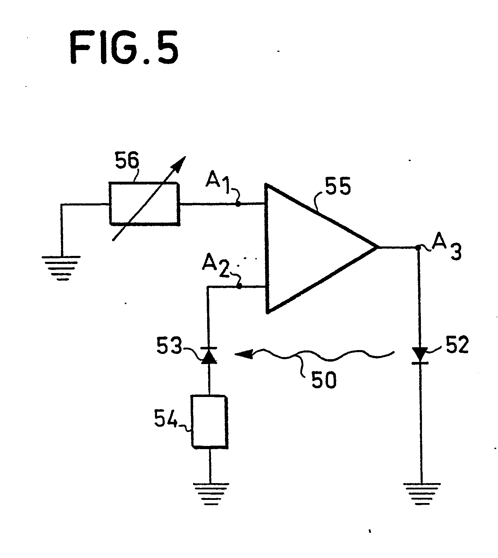

A la figure 5, on a représenté un tel dispositif, d'un exemple de réalisation dans lequel les régions centrale et annulaire du composant de la figure 4 sont respectivement représentés par le schéma théorique d'une diode électroluminescente et par celui d'une photodiode 53. On a dessiné sous la forme d'une flèche orientée de la photodiode 53 vers la diode 52 le rayonnement de photons 50 issus de l'une vers l'autre et franchissant le sillon 5 (ici non représenté)

Le dispositif de régulation comporte un amplificateur différentiel du type à courant continu, 55, dont la sortie $A_3$ est reliée à la masse à travers la diode 52. L'alimentation (non figurée) de l'amplificateur est telle que le courant de sortie traverse la diode 52 dans le sens direct. Les entrées $A_1$ et $A_2$ de l'amplificateur 55 sont respectivement reliées à la masse à travers une source de tension de référence règlable 56 et la photodiode 53 polarisée en inverse grâce à l'insertion d'une source de tension continue 54.

Le fonctionnement du dispositif est le suivant :

Les photons 50, qui représentent une fraction constante, bien que très petite, des photons émis par la surface frontale de la diode 52, donnent grâce à la photodiode 52 une tension de détection en $A_2$ qui est en relation

fidèle avec la puissance lumineuse émise par la diode 53. Cette tension est comparée, à l'entrée de l'amplificateur différentiel 55, avec la tension de référence présente en $A_1$ pour un règlage donné de la source 56. Le montage interne de l'amplificateur différentiel est tel que, si la tension en $A_2$ est inférieure à la tension de référence, la tension baisse en $A_3$, et inversement. On parvient ainsi à un état d'équilibre, dans lequel les tension sur les entrées $A_1$ et $A_2$ s'égalisent. Il y a donc régulation en fonction du règlage de la source 56.

En outre certaines précautions, par ailleurs classiques en opto-électronique, doivent être prises pour assurer un fonctionnement aussi satisfaisant que possible du composant selon l'invention. Il convient notamment de passiver correctement les surfaces des éléments semiconducteurs placés à l'air libre et, en outre, de munir les interfaces air-semiconducteur de couches du type dit "anti-reflet".

## REVENDICATIONS

1. Composant opto-électronique, du type comportant en dépôts successifs sur un même substrat semiconducteur, au moins une première, une deuxième et une troisième couches de composition et de dopages tels que :

- la première et la troisième couches sont constituées par un premier matériau semiconducteur formé de composés d'éléments III-V, présentant une bande interdite assez large pour être traversée par un rayonnement de longueur d'onde prédéterminée, avec des dopages procurant des types de conductivité opposés ;

- la deuxième couche est constituée par un matériau semiconducteur formé d'un composé d'éléments III-V, présentant une bande interdite correspondant à l'émission par ce matériau d'un rayonnement sur ladite longueur d'onde, la structure dudit composant comportant une première partie destinée à l'émission et une deuxième partie destinée à la réception sur ladite longueur d'onde, les deux parties étant séparées soit par une tranchée pénétrant dans l'ensemble des couches, soit par une région isolante obtenue par implantation protonique atteignant le substrat ;

le composant étant caractérisé en ce que deuxième partie de la structure entoure la première partie de ladite structure, les différentes couches étant respectivement coplanaires dans la première et dans la deuxième partie.

2. Composant selon la revendication 1, caractérisé en ce que le substrat étant en In P fortement dopé dans un premier type de conductivité, la première couche est en In P moins fortement dopé que le substrat dans le même type de conductivité, la deuxième couche est moins fortement dopée que le substrat dans le même type de conductivité ou dans le type opposé, en ayant une composition de matériau semiconducteur donné par la formule

$Ga_x In_{1-x} As_Y P_{1-y}$

avec :

$0,14 \leqslant x \leqslant 0,45$

$0,30 \leqslant y \leqslant 1,00$

la troisième couche est en In P moins fortement dopé que le substrat dans le type de conductivité opposé.

3. Composant selon la revendication 1, caracté en ce qu'il comporte,

en outre, une quatrième couche plus fortement dopée que la troisième dans le même type de conductivité constituée par un matériau de même composition que la troisième couche, cette quatrième couche étant limitée à la première partie de la structure.

4. Composant selon la revendication 1, caractérisé en ce que le substrat étant en Ga As, la première couche est en matériau moins fortement dopé que le substrat, dans le même type de conductivité, de composition donnée par la formule :

$Ga_{1-z'} Al_{z'} As$

avec : z' 0,2

la deuxième couche est en matériau moins fortement dopée que le substrat de composition donnée par la formule :

$Ga_{1-z}Al_z As$

avec : $0 \leq z \leq 0,15$

la troisième couche est en matériau moins fortement dopé que le substrat dans le type opposé de conductivité et de composition identique à celle de la première couche.

5. Composant selon la revendication 4, caractérisé en ce qu'il comporte en outre une quatrième couche, en matériau plus fortement dopé que la troisième couche, dans le même type de conductivité, et de composition identique à celle de la troisième couche.

6. Composant selon la revendication 1, caractérisé en ce que ladite tranchée est obtenue par gravure chimique ou par usinage ionique.

7. Composant selon la revendication 1, caractérisé en ce qu'il est obtenu par un procédé comportant les étapes suivantes :

1°/ Dépôt de la première couche par épitaxie pratiquée sur le substrat ;

2°/ Dépôt de la deuxième couche par épitaxie pratiquée sur la première couche ;

3°/ Dépôt de la troisième couche par épitaxie pratiquée sur la deuxième couche ;

4°/ Attaque mésa de la structure selon un sillon circulaire entourant la région centrale et pénétrant l'ensemble des couches.

5°/ Gravure mésa de la périphérie de la structure pratiquée jusqu'au

substrat inclusivement ;

6°/ Dépôt de contacts ohmiques respectivement sur la première, la deuxième partie de la structure et sur la périphérie du substrat.

8. Dispositif de régulation d'une diode électroluminescente constituant la première partie de la structure d'un composant selon la revendication 1, caractérisé en ce qu'il comporte un amplificateur différentiel dont une première entrée est reliée à une source de signal de référence, une deuxième entrée est reliée à la deuxième partie dudit composant, et la sortie est reliée à la diode électroluminescente.

FIG.1

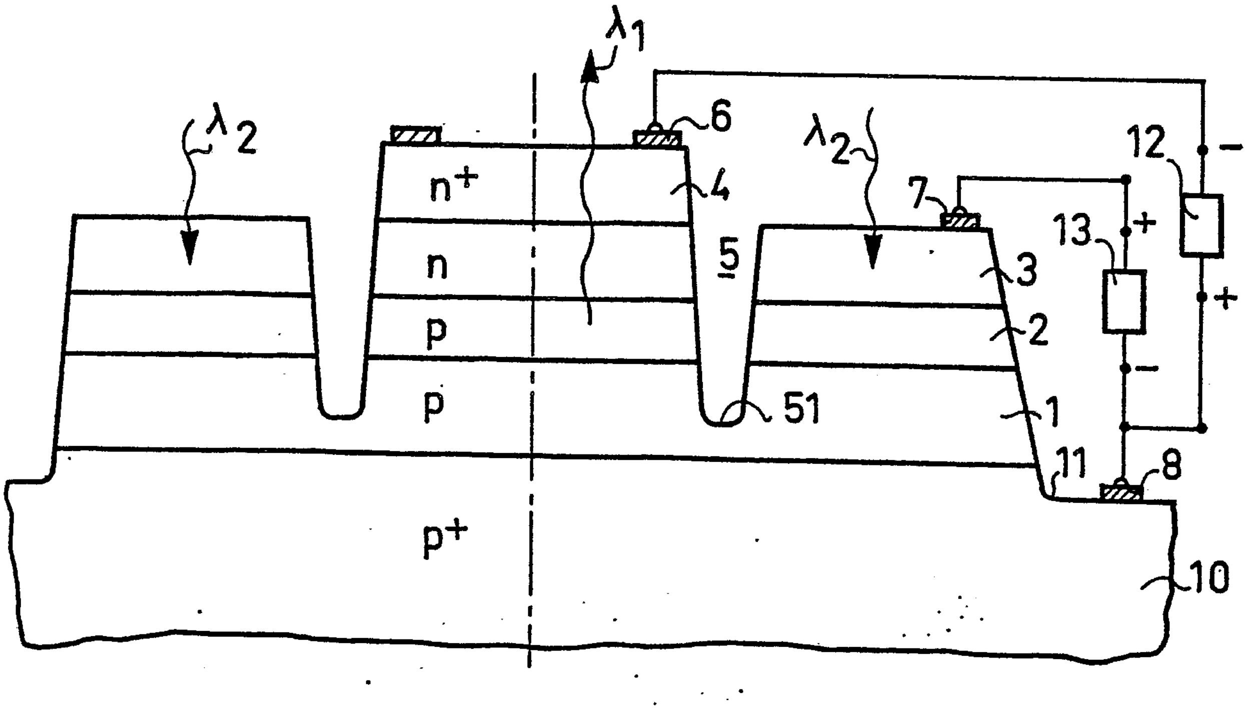
λ1
λ2
λ2
6
n+
4
7
12
−
13
+
n
5
3
p
2
+
−
p
51
1
11
8
p+
10

FIG.2

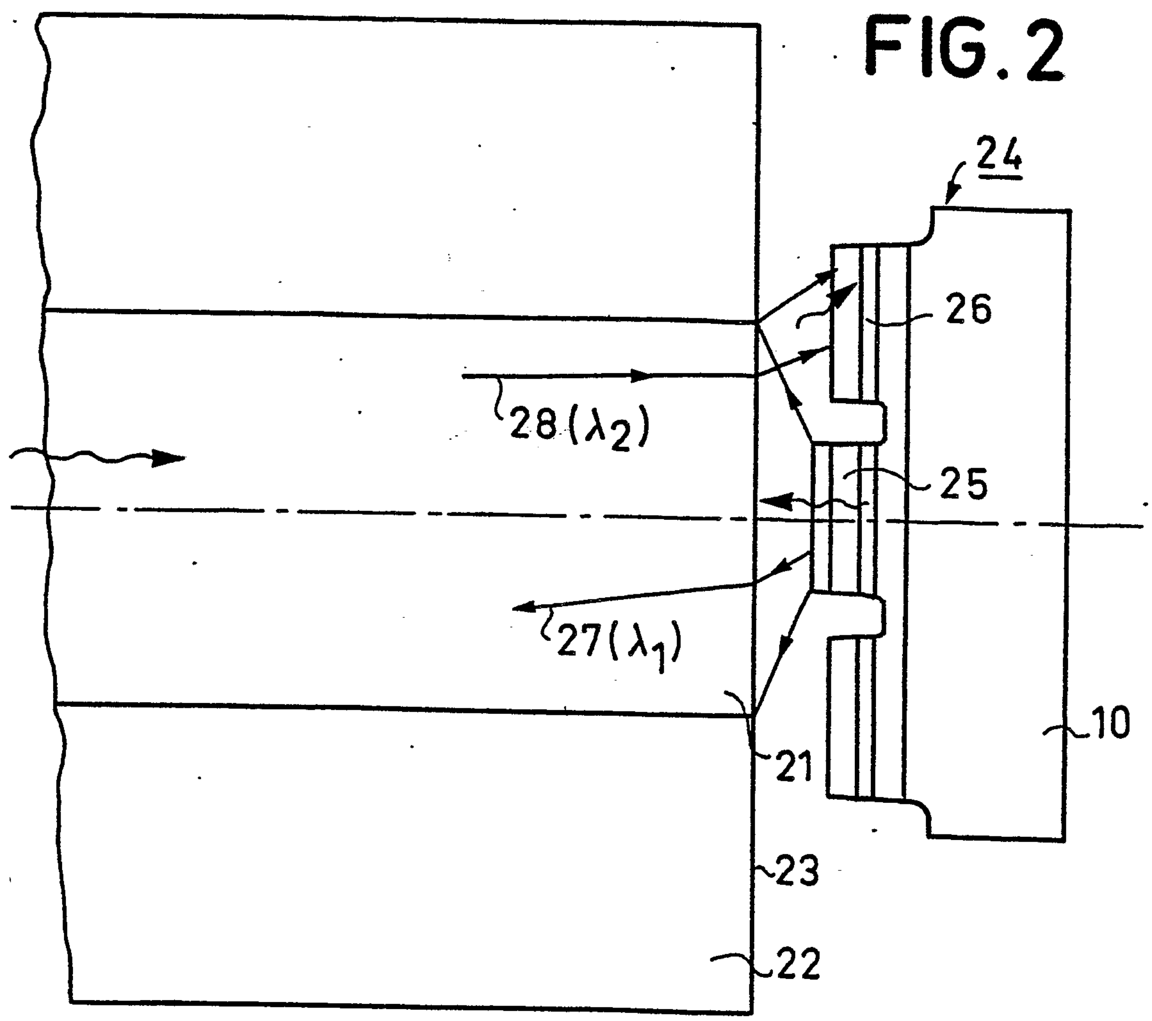
24
26
28(λ2)
25
27(λ1)
10
21
23
22

FIG.3

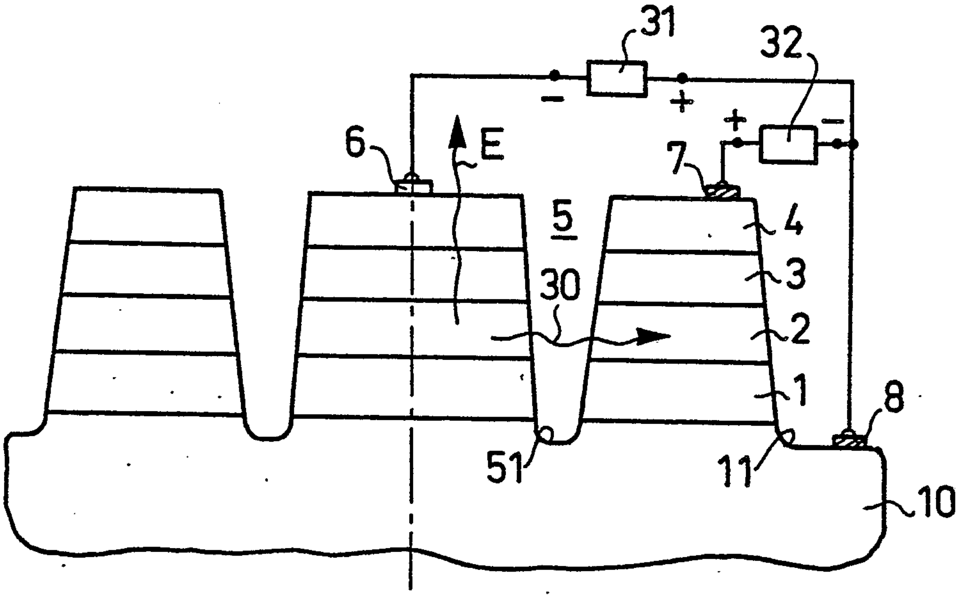


FIG.4

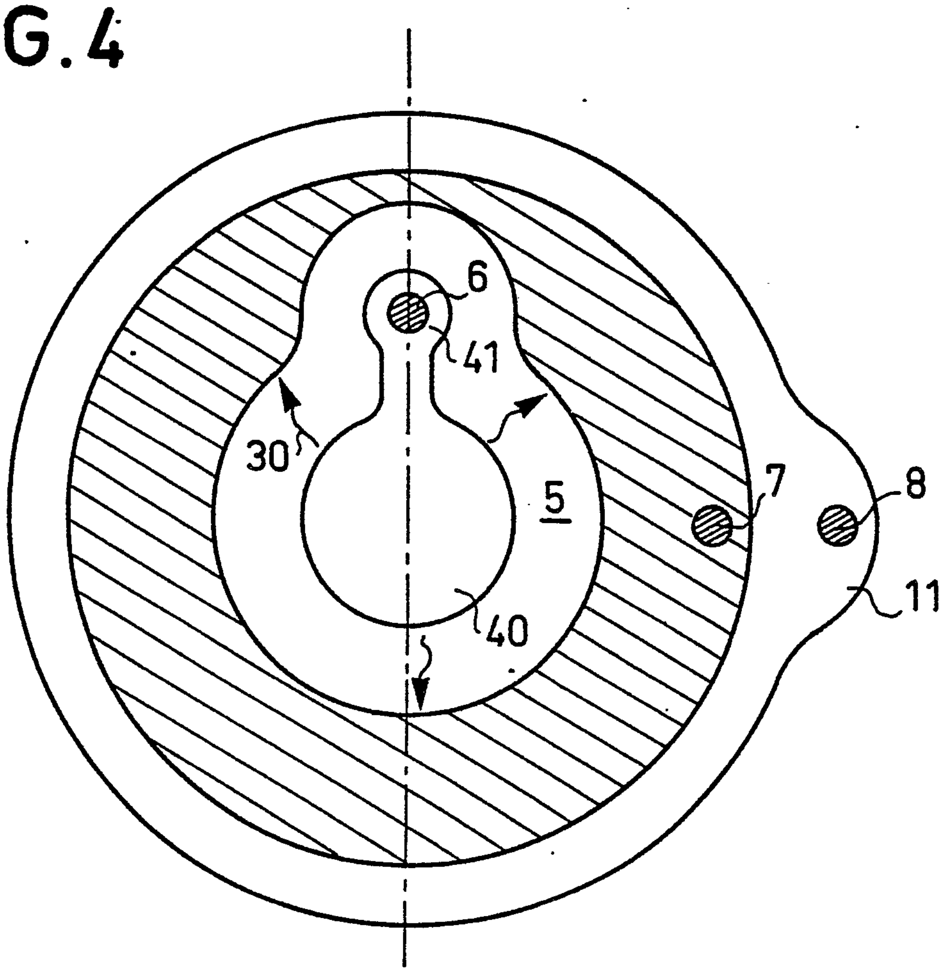

FIG.5